Europäisches Patentamt

European Patent Office

Office européen des brevets

(19)

(11) Publication number:

**0 325 454**
**A2**

(12)

# EUROPEAN PATENT APPLICATION

(21) Application number: **89300499.4**

(22) Date of filing: **19.01.89**

(51) Int. Cl.⁴: **H 02 M 7/10**

(30) Priority: **20.01.88 JP 8381/88**

(43) Date of publication of application:
**26.07.89 Bulletin 89/30**

(84) Designated Contracting States: **BE DE GB SE**

(71) Applicant: **Oki Electric Industry Company, Limited**
**7-12, Toranomon 1-chome Minato-ku**
**Tokyo 105 (JP)**

(72) Inventor: **Ishimura, Katsuhiro**
**c/o 7-12, Toranomon 1-chome**
**Minatoku Tokyo (JP)**

**Aoki, Shusei**
**c/o 7-12, Toranomon 1-chome**
**Minatoku Tokyo (JP)**

(74) Representative: **Boydell, John Christopher et al**
**Stevens, Hewlett & Perkins 5 Quality Court Chancery**
**Lane**
**London, WC2A 1HZ (GB)**

(54) **High voltage generating circuit for light reception.**

(57) In a high-voltage generating circuit for light reception, a current driving circuit (2) is provided to current-amplify pulses generated by a pulse oscillating circuit (1). A boosting and rectifying circuit, such as a Cockcroft-Walton circuit (4), receives boosts and rectifies the current-amplified pulses and provides the boosted and rectified voltage as the output of the high-voltage generating circuit. A capacitor (3), which may be part of the boosting and rectifying circuit, is provided at the input of the boosting and rectifying circuit to provide DC isolation from the current driving circuit (2).

FIG. 1

1 PULSE OSCILLATING CIRCUIT   2 CURRENT DRIVING CIRCUIT

5 LOW-PASS FILTER   4 COCKCROFT-WALTON CIRCUIT   6 APD

## Description

## HIGH VOLTAGE GENERATING CIRCUIT FOR LIGHT RECEPTION

The present invention relates to a high-voltage generating circuit for light reception for use in the receiver circuit of an optical transmission device.

When an avalanche photodiode (APD) is used as a light-receiving element in the receiver circuit of an optical transmission device, a high voltage generating circuit for generating a high voltage for inducing internal amplification function in the APD is required.

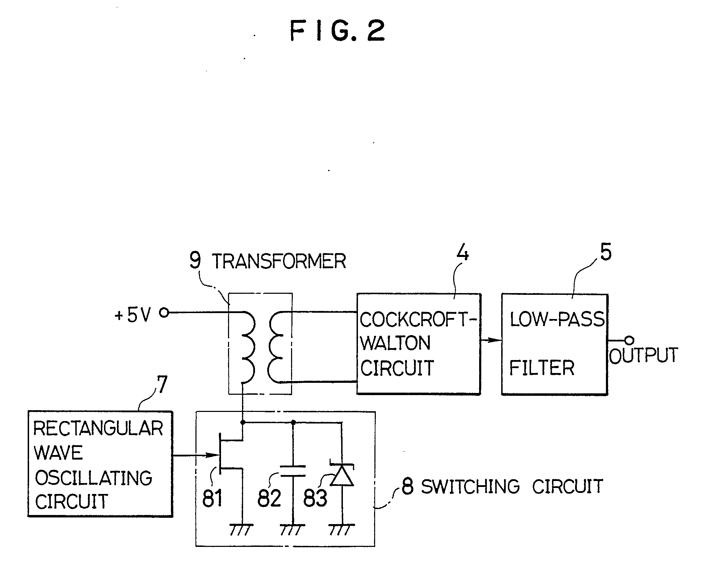

Figure 2 shows an example of a prior art high-voltage generating circuit for light reception (such as the one shown in Showa 61-nen Denshi Tsushin Gakkai Sogo Zenkoku Taikai Koen Ronbunshu; (1986 General Meeting of the Institute of Electronics and Communication Engineers of Japan), March 5, 1986, Paper No. 2485. In Figure 2, a rectangular wave generating circuit 7 produces pulses of about 100kHz and outputs them through an internal CMOS inverter to a switching circuit 8. A MOSFET 81 in the switching circuit 8 performs switching responsive to the above-mentioned pulses and causes production of pulses of a large amplitude in the primary side of a transformer 9 which resonates with a capacitor 82. A constant-voltage diode 83 is provided for stabilizing the output voltage. The pulses generated in the primary side of the transformer 9 are boosted by the transformer 9, and are further boosted and rectified by a Cockcroft-Walton circuit 4, and are then passed through a low-pass filter for removal of ripple components. The boosted and rectified voltage obtained at the output of the Cockcroft-Walton circuit 4 is used as a high-voltage power supply for light reception.

In the above high-voltage generating circuit for light reception, a MOSFET and a transformer which is difficult to reduce in size and is not suitable for mounting on a plane are utilized, so that miniaturization of the circuit is difficult.

The present invention seeks to remove the above shortcomings and to provide a high-voltage generating circuit for light reception which can be reduced in size and simplified.

According to the invention there is provided a high-voltage generating circuit comprising a pulse oscillating circuit for generating pulses, a current driving circuit for current-amplifying said pulses, a capacitor for admitting the current-amplified pulses, and a boosting and rectifying circuit receiving the pulses through said capacitor and boosting and rectifying the pulses.

In order that the invention may be better understood, an embodiment thereof will now be described by way of example only and with reference to the accompanying drawings in which:-

Figure 1 is a high-voltage generating circuit for light reception according to the invention; and

Figure 2 is a prior-art high-voltage generating circuit for light reception.

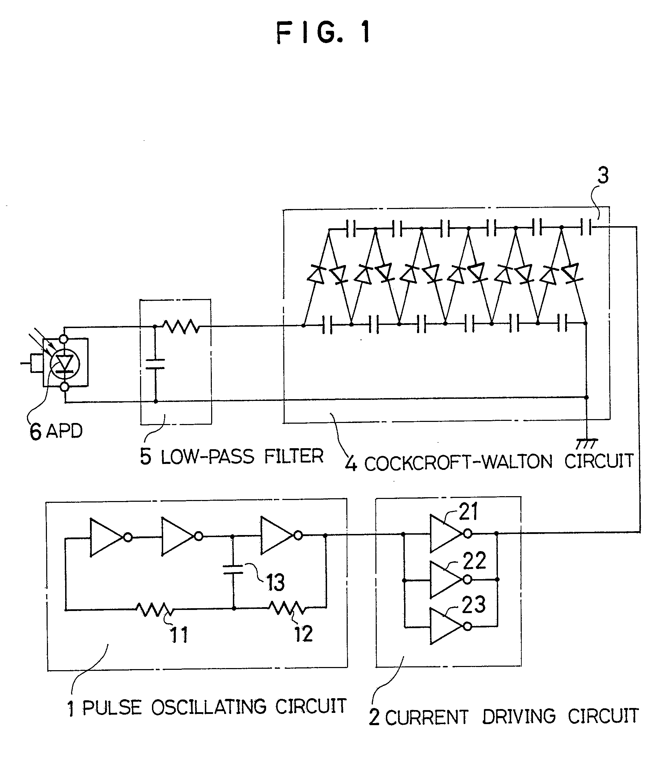

Figure 1 illustrates an embodiment of the invention, The high-voltage generating circuit of this embodiment comprises a pulse oscillating circuit 1 utilizing CMOS gates, and a current driving circuit 2 having CMOS gates 21,22 and 23 connected in parallel with each other. Each of the CMOS gates may comprise CMOS inverters cascaded with each other. A Cockcroft-Walton circuit 4 is connected to receive the output of the current driving circuit 21 through a capacitor 3 provided at one of its inputs. A low-pass filter 5 is provided at the output of the Cockcroft-Walton circuit 4. An avalanche photodiode (APD) 6 is connected to receive the output of the low-pass filter 5. The APD is used for optical transmission and must be energized with a high voltage for its internal amplification function. The oscillating frequency of the oscillating circuit 1 is a frequency inversely proportional to the time constant determined by the product of the resistor 12 and the capacitor 13.

In Figure 1, the pulses output from the pulse oscillating circuit 1 are current-amplified by the current driving circuit 2, and drive the Cockcroft-Walton circuit 4. The output of the pulse oscillating circuit 1 is in the form of a CMOS gate and the current drive capacity is limited, and if this output were used to drive the Cockcroft-Walton circuit 4 directly the high voltage required for the APD 6 would not be obtained at the output of the Cockroft-Walton circuit 4. This is why the current driving circuit 2 is employed to enhance the current driving capacity. The Cockcroft-Walton circuit 4 is an example of a boosting and rectifying circuit, and is formed of a plurality of diodes and capacitors, and boosts and rectifies the input pulses and outputs a high DC voltage. The high DC voltage is passed through the low-pass filter 5 for removal of the ripple components, and is then applied to the APD 6.

As has been described, according to the above embodiment, the circuit is constructed without resorting to a MOSFET and a transformer, the circuit can be miniaturized and simplified.

When a Cockcroft-Walton circuit is used as the boosting and rectifying circuit, a capacitor is provided at its input, so it is not necessary to provide a separate capacitor for DC isolation from the current driving circuit. When a boosting and rectifying circuit is formed of a circuit itself which does not have a capacitor at its input for DC isolation, a separate capacitor must be interposed between the boosting and rectifying circuit and the current driving circuit.

As has been described, the pulse oscillating circuit is connected to the current driving circuit for enhancement of the current driving capacity for the boosting and rectifying circuit, and a capacitor is used between the current driving circuit and the boosting and rectifying circuit to eliminate the need for switching elements such as MOSFET and transformers, it is therefore possible to miniaturize the circuit and the circuit can be simplified, the reliability can be improved, and the cost can be reduced.

## Claims

1. A high-voltage generating circuit for light reception comprising:
a pulse oscillating circuit for generating pulses;
a current driving circuit for current-amplifying said pulses;
a capacitor for admitting the current-amplified pulses; and
a boosting and rectifying circuit for receiving the pulses through said capacitor, and boosting and rectifying the pulses.

2. A circuit according to Claim 1, wherein said boosting and rectifying circuit comprises a Cockcroft-Walton circuit, and said capacitor forms part of said Cockcroft-Walton circuit.

3. A circuit according to Claim 1, wherein said current driving circuit comprises a plurality of CMOS gates circuits connected in parallel with each other.

4. A circuit according to Claim 1, further comprising a low-pass filter connected at the output of the boosting and rectifying circuit for removing the ripple components of the output of the boosting and rectifying circuit.

5. A circuit according to Claim 1, wherein said circuit is for avalanche photodiodes.

6. A high-voltage generating circuit for light reception comprising:
a pulse oscillating circuit for generating pulses;
a current driving circuit for current-amplifying said pulses; and
a Cockcroft-Walton circuit for receiving the pulses from said current driving circuit, to provide a boosted and rectified voltage.

7. A circuit according to Claim 6, wherein said Cockcroft-Walton circuit comprises a capacitor through which it receives said pulses from said current driving circuit, said capacitor being used to provide DC isolation between the current driving circuit and the remainder of said Cockcroft-Walton circuit.

8. A circuit according to Claim 6, wherein said current driving circuit comprises a plurality of CMOS gate circuits connected in parallel with each other.

9. A circuit according to Claim 6, further comprising a low-pass filter connected at the output of the boosting and rectifying circuit for removing the ripple components of the output of the boosting and rectifying circuit.

10. A circuit according to Claim 6, wherein said circuit is for avalanche photodiodes.

# F I G. 1

6 APD

5 LOW-PASS FILTER

4 COCKCROFT-WALTON CIRCUIT

3

13

11

12

1 PULSE OSCILLATING CIRCUIT

21

22

23

2 CURRENT DRIVING CIRCUIT

# FIG. 2

9 TRANSFORMER

+5V

COCKCROFT-
WALTON
CIRCUIT
4

LOW-PASS
FILTER
5

OUTPUT

7

RECTANGULAR
WAVE
OSCILLATING
CIRCUIT

81  82  83

8 SWITCHING CIRCUIT